# EUROPEAN PATENT APPLICATION

(11) **EP 1 728 585 A1**
(43) Date of publication of application: **06.12.2006**
(21) Application number: 06011227.3
(22) Date of filing: 31.05.2006
(51) Int. Cl.: B23K 35/36, H01L 21/56, H05K 3/34

(54) **Fluxing compositions**

(30) Priority: 03.06.2005 US 144571
(71) Applicant: National Starch and Chemical Investment Holding Corporation, New Castle, Delaware 19720 (US)
(72) Inventor: Wang, Renyi, Irvine California 92602 (US); Liu, Zhen, Monterey Park California 91754 (US); Bao, Lirong, Hillsborough New Jersey 08844 (US); Tran, Trang, Westminster California 92683 (US)
(74) Representative: Held, Stephan

(57) **Abstract**

A fluxing composition comprises a fluxing agent in which the fluxing agent is a compound having (i) an aromatic ring, (ii) at least one -OH, -NHR (where R is hydrogen or lower alkyl), or-SH group (iii) an electron-withdrawing or electron-donating substituent on the aromatic ring, and (iv) no imino group.

## Description

### FIELD OF THE INVENTION

This invention relates to fluxing compositions and their application in electronic packaging, particularly within no-flow underfill compositions and pre-applied wafer level underfill for flip-chip based semiconductor packages and electronic assemblies. These compositions also have application for refluxing the solder during solder reflow prior to a capillary underfill process.

### BACKGROUND OF THE INVENTION

An increasingly important method for attaching an integrated circuit onto a substrate in semiconductor packaging operations is the so-called flip-chip technology. In flip-chip technology, the active side of the semiconductor die is bumped with metallic solder balls and flipped so that the solder balls can be aligned and placed in contact with corresponding electrical terminals on the substrate. Electrical connection is realized when the solder is reflowed to form metallurgical joints with the substrates. The coefficients of thermal expansion (CTE) of the semiconductor die, solder, and substrate are dissimilar and this mismatch stresses the solder joints, which ultimately can lead to failure of the semiconductor package.

Organic materials, often filled with organic or inorganic fillers or spacers, are used to underfill the gap between the die and the substrate to offset the CTE mismatch and to provide enforcement to the solder joints. Such underfill materials can be applied through a capillary effect, by dispensing the material along the edges of the die-substrate assembly after solder reflow and letting the material flow into the gap between the die and substrate. The underfill is then cured, typically by the application of heat.

In an alternative process, an underfill material is pre-applied onto a solder bumped semiconductor wafer, either through printing if the material is a paste, or through lamination if the material is a film. The wafer is singulated into dies and an individual die subsequently bonded onto the substrate during solder reflow, typically with the assistance of temperature and pressure, which also cures the underfill material.

In another process, known as no-flow, a substrate is pre-dispensed with an underfill material, a flip-chip is placed on top of the underfill, and, typically with the assistance of temperature and pressure, the solder is reflowed to realize the interconnection between the die and substrate. These conditions may cure the underfill material, although sometimes an additional cure step is necessary. The reflow process is typically accomplished on thermal compression bonding equipment, within a time period that can be as short as a few seconds.

In all three of these underfill operations, a key criterion is that the solder must be fluxed either before or during the reflow operation to remove any metal oxides present, inasmuch the presence of metal oxides hinders reflow of the solder, wetting of the substrate by the solder, and electrical connection. For capillary flow operations, fluxing and removal of flux residues is conducted before the addition of the capillary flow underfill. For the no-flow and pre-applied underfill operations, the fluxing agent typically is added to the underfill material.

Many current no-flow underfill resins are based on epoxy chemistry, which achieve solder fluxing by using carboxylic acids or anhydrides. Organic alcohols are sometimes used as accelerators, since they can react with anhydrides to form carboxylic acids, which in turn flux the solder. The carboxylic acids from the anhydrides are volatile during the thermal compression bonding process, and may cause corrosion of the semiconductor packages.

Moreover, anhydride based fluxing agents are not suitable for chemistries that are sensitive to acidic species, such as, cyanate ester based underfill resins. The more reactive anhydrides are too aggressive, causing the resin monomers and oligomers to advance, leading to short resin pot life and voiding during curing. The voiding can negatively impact the interconnections between the solder balls and substrates, causing short circuits and joint failure.

### BRIEF DESCRIPTION OF THE DRAWINGS

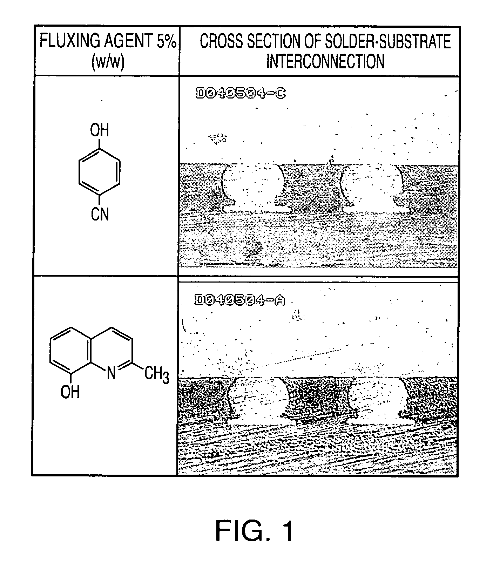

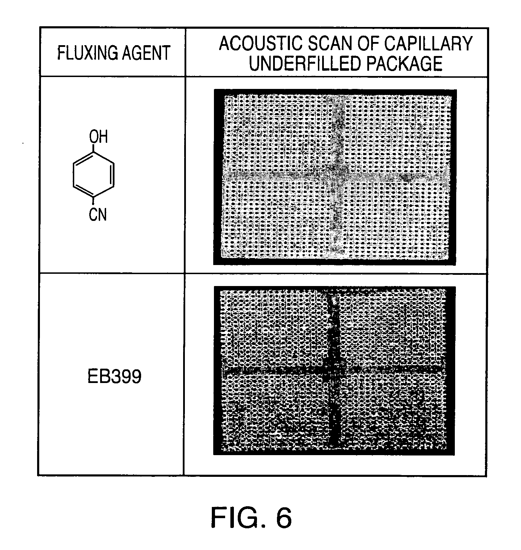

FIGURES 1 to 5 are scanning electronic microscopy photos of solder joint interconnections and drawings of fluxing agents used in underfill formulations supporting those interconnections . Figure 6 is an acoustic scanning of eutectic solder on pad as circuitry.

### SUMMARY OF THE INVENTION

This invention is a fluxing composition comprising a fluxing agent, in which the fluxing agent is a compound having (i) an aromatic ring, (ii) at least one -OH, -NHR (where R is hydrogen or lower alkyl), or -SH group, (iii) an electron-withdrawing or electron-donating substituent on the aromatic ring, and (iv) no imino group. For purposes of this specification and the claims, aromatic is deemed to include five- and six-membered ring structures, including heterocyclic ones, that have delocalized 4n + 2 pi electrons. The aromatic ring may be fused with one or more aliphatic or other aromatic ring structures. The -OH, -NH, or -SH group protons on the fluxing agent have pKa values roughly in the range of 5 to 14, and yet are capable of acting as fluxes for metals or metallic materials.

### DETAILED DESCRIPTION OF THE INVENTION

The fluxing agents used in the fluxing compositions of this invention will have electron withdrawing or electron donating groups on the aromatic ring portion of the compound. Exemplary electron-withdrawing groups are known to those skilled in the art and include: -C₆H₅, -N(CH₃)₃⁺, -NO₂,-CN, -SO₃H, -COOH, -CHO, -COR and -X (halogens). Exemplary electron-donating groups are known to those skilled in the art and include: -NHR, -OH, -OCH₃, -NHCOCH₃, -CH₃ (in which R is hydrogen or lower alkly). In those compounds in which electron-withdrawing groups are present, the ability of the -OH, -NHR or -SH protons to disassociate is increased, and, consequently, they perform well as fluxes. In those compounds in which electron-donating groups are present, the ability of the compound to act as a reductant to the metal oxides is increased, and consequently, they perform well as fluxes. Thus, the inventors believe that the fluxing mechanism for the fluxing agents discovered in the present invention is likely a mixture of acid/base chemistry and redox chemistry between the fluxing agents and solder metal oxides.

Exemplary compounds that meet the definition of fluxing agents for the fluxing compositions of this invention include, but are not limited to, those following. Some of the compounds were tested for fluxing performance as described in Example 1, and the time until the solder ball collapsed is reported in seconds immediately below those compounds.

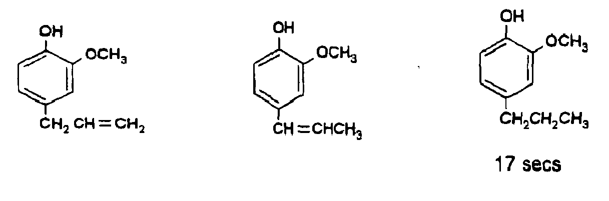

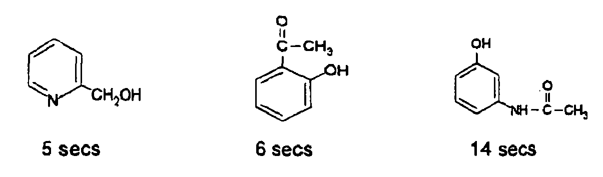

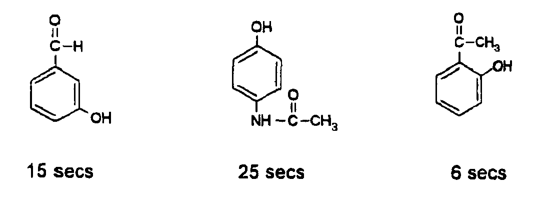

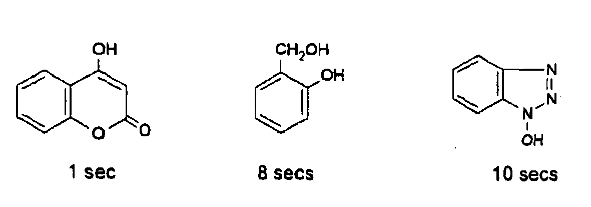

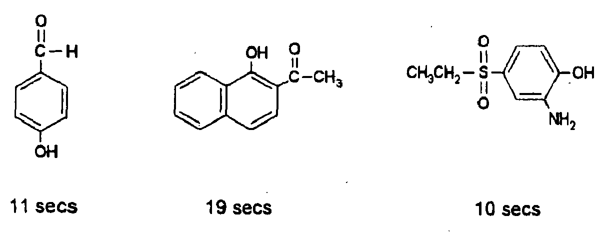

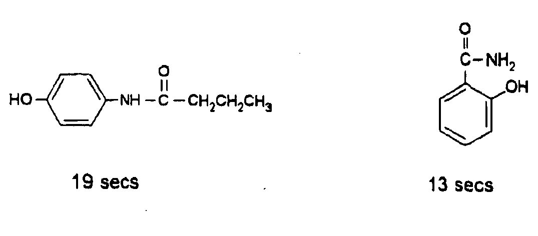

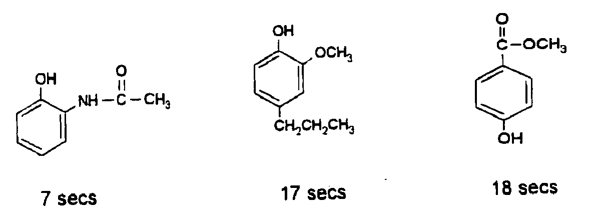

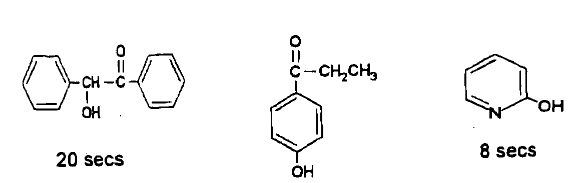

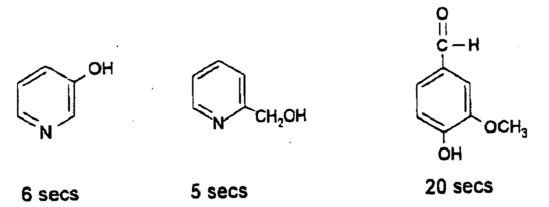

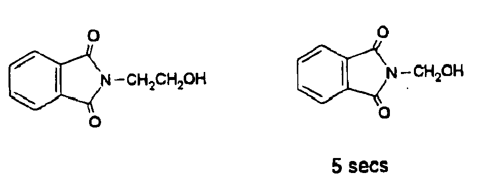

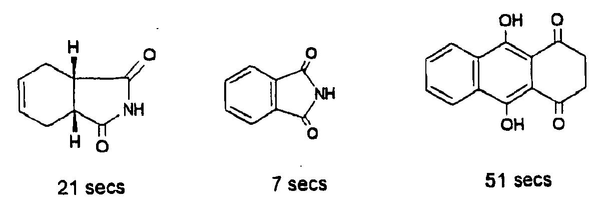

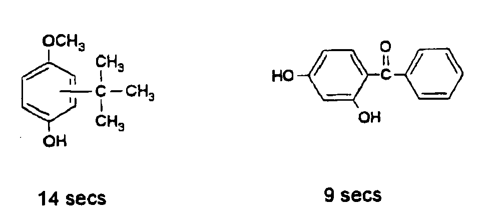

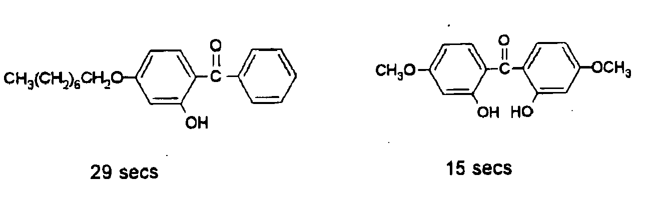

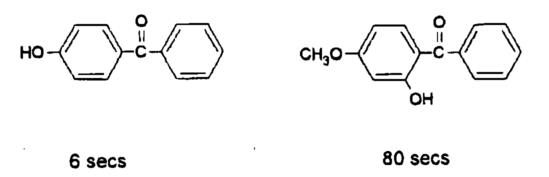

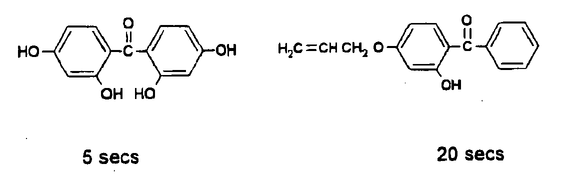

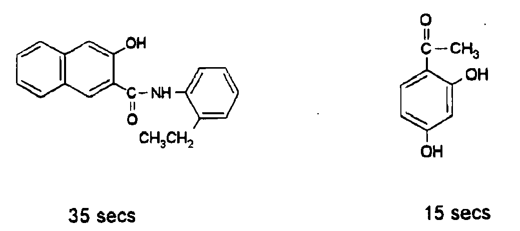

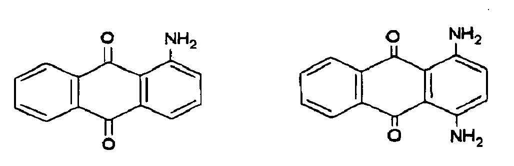

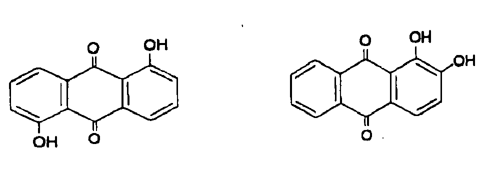

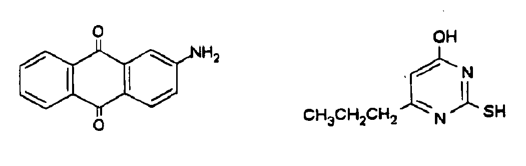

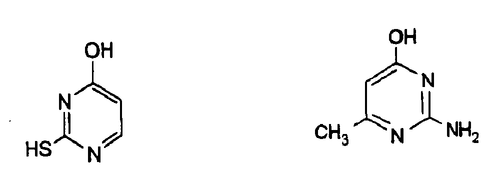

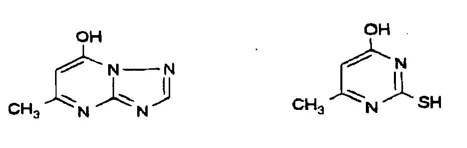

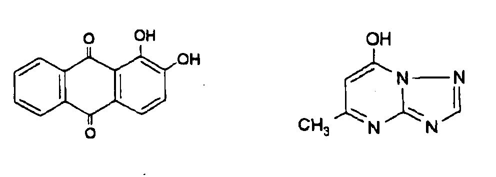

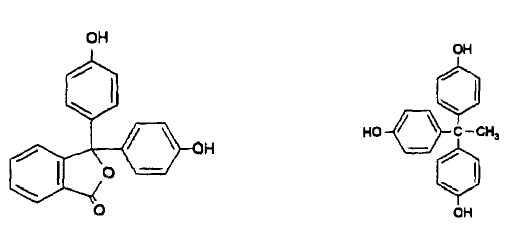

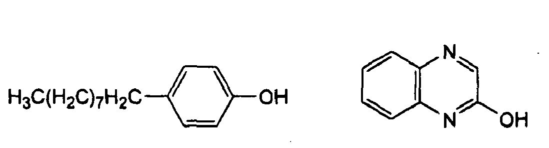

In one embodiment, the fluxing composition can be used to flux solders in a capillary underfill operation as described in the Background section of this specification. In that case, the fluxing composition will comprise a fluxing agent or a combination of several fluxing agents, a solvent or a combination of several solvents, and optional additives, such as dispersing agents and defoamers.

When used in a capillary flow operation, the thermal stability of the fluxing agent should be sufficient to withstand the elevated temperature at which the solder is reflowed. The solder reflow temperature will depend on the solder composition, and will vary with the actual metallurgy. The practitioner will be able to make the determination of the solder reflow temperature by heating the solder until it reflows. The determination of the thermal stability of the fluxing agent can be readily assessed by thermal gravimetric analysis (TGA), a technique well within the expertise of one skilled in the art.

In another embodiment, the fluxing composition of this invention comprises one or more resins; optionally, one or more curing agents for those resins; and optionally conductive or nonconductive fillers. The curable resin will be present in an amount from 10 to 99.5 weight %; the curing agent, if present, will be present in an amount up to 30 weight %; the fillers, if present, will be present in an amount up to 80 weight %; and the fluxing agent will be present in an amount from 0.5 to 30 weight %.

Suitable resins for the fluxing composition include, but are not limited to, epoxy, polyamide, phenoxy, polybenzoxazine, acrylate, cyanate ester, bismaleimide, polyether sulfone, polyimide, benzoxazine, vinyl ether, siliconized olefin, polyolefin, polybenzoxyzole, polyester, polystyrene, polycarbonate, polypropylene, poly(vinyl chloride), polyisobutylene, polyacrylonitrile, poly(methyl methacrylate), poly(vinyl acetate), poly(2-vinylpyridine), cis-1,4-polyisoprene, 3,4-polychloroprene, vinyl copolymer, poly(ethylene oxide), poly(ethylene glycol), polyformaldehyde, polyacetaldehyde, poly(b-propiolacetone), poly(10-decanoate), poly(ethylene terephthalate), polycaprolactam, poly(11-undecanoamide), poly(m-phenylene-terephthalamide), poly(tetramethlyene-m-benzenesulfonamide), polyester polyarylate, poly(phenylene oxide), poly(phenylene sulfide), polysulfone, polyetherketone, polyetherimide, fluorinated polyimide, polyimide siloxane, polyisoindolo-quinazolinedione, polythioetherimide, polyphenylquinoxaline, polyquinixalone, imide-aryl ether phenylquinoxaline copolymer, polyquinoxaline, polybenzimidazole, polybenzoxazole, polynorbomene, poly(arylene ethers), polysilane, parylene, benzocyclobutenes, hydroxy(benzoxazole) copolymer, poly(silarylene siloxanes), and polybenzimidazole.

In one embodiment, suitable resins include cyanate esters, epoxies, bismaleimides, (meth)acryates, and a combination of one or more of these. In a further embodiment, the resin is a cyanate ester, which can be used in these compositions because the fluxing agents have been selected to have weak acidity. It is known that cyanate esters are sensitive to acidic conditions, and for that reason, have not been used frequently in underfill compositions that contain fluxing agents. Thus, in one embodiment, this invention is a fluxing composition comprising a cyanate ester resin, a curing agent for the cyanate ester resin, a fluxing agent as described herein, and optionally conductive or nonconductive fillers.

Suitable cyanate ester resins include those having the generic structure 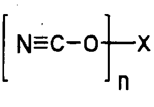 in which n is 1 or larger, and X is a hydrocarbon group. Exemplary X entities include, but are not limited to, bisphenol A, bisphenol F, bisphenol S, bisphenol E, bisphenol O, phenol or cresol novolac, dicyclopentadiene, polybutadiene, polycarbonate, polyurethane, polyether, or polyester. Commercially available cyanate ester materials indude; AroCy L-10, AroCy XU366, AroCy XU371, AroCy XU378, XU71787.02L, and XU 71787.07L, available from Huntsman LLC; Primaset PT30, Primaset PT30 S75, Primaset PT60, Primaset PT60S, Primaset BADCY, Primaset DA230S, Primaset MethylCy, and Primaset LECY, available from Lonza Group Limited; 2-allyphenol cyanate ester, 4-methoxyphenol cyanate ester, 2,2-bis(4-cyanatophenol)-1,1,1,3,3,3-hexafluoropropane, bisphenol A cyanate ester, diallylbisphenol A cyanate ester, 4-phenylphenol cyanate ester, 1,1,1-tris(4-cyanatophenyl)ethane, 4-cumylphenol cyanate ester, 1,1-bis(4-cyanatophenyl)ethane, 2,2,3,4,4,5,5,6,6,7,7-dodecafluorooctanediol dicyanate ester, and 4,4'-bisphenol cyanate ester, available from Oakwood Products, Inc.

Suitable epoxy resins include bisphenol, naphthalene, and aliphatic type epoxies. Commercially available materials include bisphenol type epoxy resins (Epiclon 830LVP, 830CRP, 835LV, 850CRP) available from Dainippon Ink & Chemicals, Inc.; naphthalene type epoxy (Epiclon HP4032) available from Dainippon Ink & Chemicals, Inc.; aliphatic epoxy resins (Araldite CY179, 184, 192, 175, 179) available from Ciba Specialty Chemicals, (Epoxy 1234, 249, 206) available from Dow, and (EHPE-3150) available from Daicel Chemical Industries, Ltd. Other suitable epoxy resins include cycloaliphatic epoxy resins, bisphenol-A type epoxy resins, bisphenol-F type epoxy resins, epoxy novolac resins, biphenyl type epoxy resins, naphthalene type epoxy resins, dicyclopentadienephenol type epoxy resins.

Suitable maleimide resins include those having the generic structure 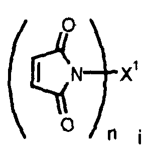 in which n is 1 to 3 and X¹ is an aliphatic or aromatic group. Exemplary X¹ entities include, poly(butadienes), poly(carbonates), poly(urethanes), poly(ethers), poly(esters), simple hydrocarbons, and hydrocarbons containing functionalities such as carbonyl, carboxyl, ester, amide, carbamate, urea, or ether. These types of resins are commercially available and can be obtained, for example, from Dainippon Ink and Chemical, Inc.

Additional suitable maleimide resins include, but are not limited to, solid aromatic bismaleimide resins, particularly those having the structure 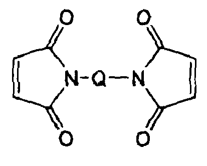 in which Q is an aromatic group; exemplary aromatic groups include: 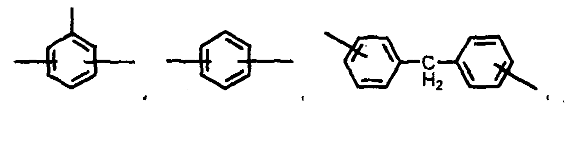 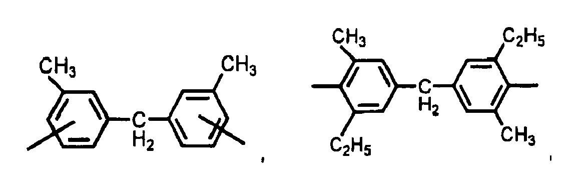 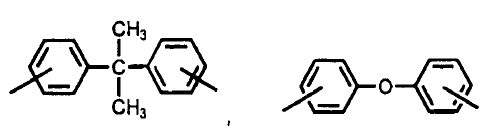 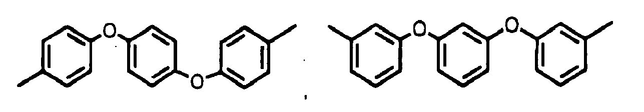 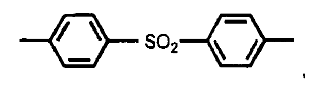 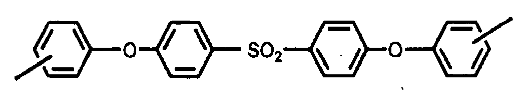 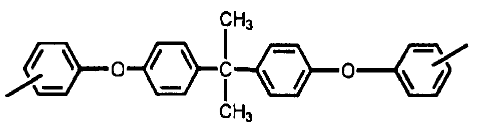 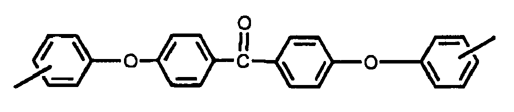 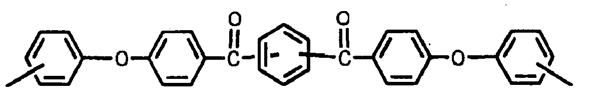 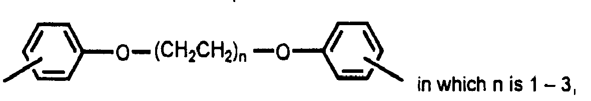 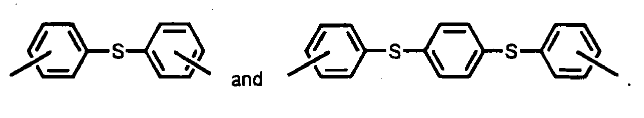 Maleimide resins having these Q bridging groups are commercially available, and can be obtained, for example, from Sartomer (USA) or HOS-Technic GmbH (Austria).

Other suitable maleimide resins include the following: 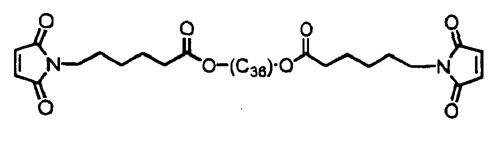 in which C₃₆ represents a linear or branched chain hydrocarbon chain(with or without cyclic moieties) of 36 carbon atoms; 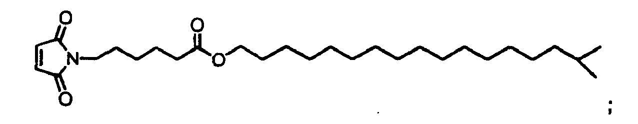 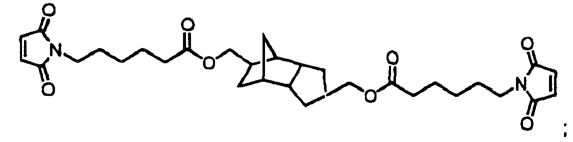 and

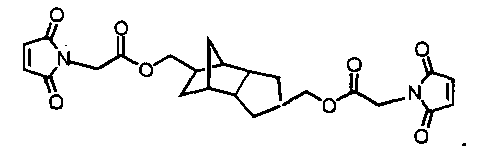

Suitable acrylate and methacrylate resins include those having the generic structure 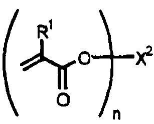 in which n is 1 to 6, R¹ is -H or -CH₃. and X² is an aromatic or aliphatic group. Exemplary X² entities include poly(butadienes), poly-(carbonates), poly(urethanes), poly(ethers), poly(esters), simple hydrocarbons, and simple hydrocarbons containing functionalities such as carbonyl, carboxyl, amide, carbamate, urea, or ether. Commercially available materials include butyl (meth)acrylate, isobutyl (meth)acrylate, 2-ethyl hexyl (meth)acrylate, isodecyl (meth)acrylate, n-lauryl (meth)acrylate, alkyl (meth)acrylate, tridecyl (meth)acrylate, n-stearyl (meth)acrylate, cyclohexyl(meth)acrylate, tetrahydrofurfuryl(meth)acrylate, 2-phenoxy ethyl(meth)acrylate, isobomyl(meth)acrylate, 1,4-butanediol di(meth)acrylate, 1.6 hexanediol di(meth)acrylate, 1,9-nonandiol di(meth)acrylate, perfluorooctylethyl (meth)acrylate, 1,10 decandiol di(meth)acrylate, nonylphenol polypropoxylate (meth)acrylate, and polypentoxylate tetrahydrofurfuryl acrylate, available from Kyoeisha Chemical Co., LTD; polybutadiene urethane dimethacrylate (CN302, NTX6513) and polybutadiene dimethacrylate (CN301, NTX6039, PRO6270) available from Sartomer Company, Inc; polycarbonate urethane diacrylate (ArtResin UN9200A) available from Negami Chemical Industries Co., LTD; acrylated aliphatic urethane oligomers (Ebecryl 230, 264, 265, 270,284, 4830, 4833, 4834, 4835, 4866, 4881, 4883, 8402, 8800-20R, 8803, 8804) available from Radcure Specialities, Inc; polyester acrylate oligomers (Ebecryl 657, 770, 810, 830, 1657, 1810, 1830) available from Radcure Specialities, Inc.; and epoxy acrylate resins (CN104, 111, 112, 115, 116, 117, 118, 119, 120, 124, 136) available from Sartomer Company, Inc. In one embodiment the acrylate resins are selected from the group consisting of isobomyl acrylate, isobomyl methacrylate, lauryl acrylate, lauryl methacrylate, poly(butadiene) with acrylate functionality and poly(butadiene) with methacrylate functionality.

Suitable vinyl ether resins are any containing vinyl ether functionality and include poly(butadienes), poly(carbonates), poiy(urethanes), poly(ethers), poly(esters), simple hydrocarbons, and simple hydrocarbons containing functionalities such as carbonyl, carboxyl, amide, carbamate, urea, or ether. Commerciatly available resins include cyclohenanedimethanol divinylether, dodecylvinylether, cyclohexyl vinylether, 2-ethylhexyl vinylether, dipropyleneglycol divinylether, hexanediol divinylether, octadecylvinylether, and butandiol divinylether available from Intemational Speciality Products (ISP); Vectomer 4010, 4020, 4030, 4040, 4051, 4210, 4220, 4230, 4060, 5015 available from Sigma-Aldrich, Inc.

Depending on the actual resin used in the fluxing composition, the curing agent can be, but is not limited to, one or more of the following: amines, triazines, metal salts, aromatic hydroxyl compounds. Examples of curing agents include imidazoles, such as 2-methylimidazole, 2-undecylimidazole, 2-heptadecyl imidazole, 2-phenylimidazole, 2-ethyl 4-methylimidazole, 1-benzyl-2-methylimidazole, 1-propyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-guanaminoethyl-2-methylimidazole and addition product of an imidazole and trimellitic acid; tertiary amines, such as N,N-dimethyl benzylamine, N,N-dimethylaniline, N,N-dimethyltoluidine, N,N-dimethyl-p-anisidine, p-halogeno-N,N-dimethylaniline, 2-N-ethylanilino ethanol, tri-n-butylamine, pyridine, quinoline, N-methylmorpholine, triethanolamine, triethylenediamine, N,N,N',N'-tetramethylbutanediamine, N-methylpiperidine; phenols, such as phenol, cresol, xylenol, resorcine, phenol novolac, and phloroglucin; organic metal salts, such as lead naphthenate, lead stearate, zinc naphthenate, zinc octolate, tin oleate, dibutyl tin maleate, manganese naphthenate, cobalt naphthenate, and acetyl aceton iron; other metal compounds, such as, metal acetoacetonates, metal octoates, metal acetates, metal halides, metal imidazole complexes, Co(II)(acetoacetonate), Cu(II)(acetoacetonate), Mn(II)(acetoacetonate), Ti(acetoacetonate), and Fe(II)(acetoacetonate); and amine complexes; inorganic metal salts, such as stannic chloride, zinc chloride and aluminum chloride; peroxides, such as benzoyl peroxide, lauroyl peroxide, octanoyl peroxide, butyl peroctoate, dicumyl peroxide, acetyl peroxide, para-chlorobenzoyl peroxide and di-t-butyl diperphthalate; acid anhydrides, such as maleic anhydride, phthalic anhydride, lauric anhydride, pyromellitic anhydride, trimellitic anhydride, hexahydrophthalic anhydride; hexahydropyromellitic anhydride and hexahydrotrimellitic anhydride, azo compounds, such as azoisobutylonitrile, 2,2'-azobispropane, m,m'-azoxystyrene, hydrozones; adipic dihydrazide, diallyl melamine, diamino malconnitrile, and BF3-amine complexes; and mixtures thereof.

The curing agent can be either a free radical initiator or ionic initiator (either cationic or anionic), depending on whether a radical or ionic curing resin is chosen, and will be present in an effective amount. For free radical curing agents, an effective amount typically is 0.1 to 10 percent by weight of the organic compounds (excluding any filler). Preferred free-radical initiators include peroxides, such as butyl peroctoates and dicumyl peroxide, and azo compounds, such as 2,2'-azobis(2-methyl-propanenitrile) and 2,2'-azobis(2-methyl-butanenitrile). For ionic curing agents or initiators, an effective amount typically is 0.1 to 10 percent by weight of the organic compounds (excluding any filler). Preferred cationic curing agents include dicyandiamide, phenol novolak, adipic dihydrazide, diallyl melamine, diamino malconitrile, BF3-amine complexes, amine salts and modified imidazole compounds.

In some cases, it may be desirable to use more than one type of cure. For example, both cationic and free radical initiation may be desirable, in which case both free radical cure and ionic cure resins can be used in the composition. Such a composition would permit, for example, the curing process to be started by cationic initiation using UV irradiation, and in a later processing step, to be completed by free radical initiation upon the application of heat

In some cases, the cure rate can be optimized by the use of cure accelerators, for example in cyanate ester systems. Cure accelerators include, but are not limited to, metal napthenates, metal acetylacetonates (chelates), metal octoates, metal acetates, metal halides, metal imidazole complexes, metal amine complexes, triphenylphosphine, alkyl-substituted imidazoles, imidazolium salts, and onium borates.

When a curing step is utilized, the cure temperature will generally be within a range of 80°-250°C, and curing will be effected within a time period ranging from few seconds or up to 120 minutes, depending on the particular resin chemistry and curing agents chosen. The time and temperature curing profile for each adhesive composition will vary, and different compositions can be designed to provide the curing profile that will be suited to the particular industrial manufacturing process.

Depending on the end application, one or more fillers may be included in the composition and usually are added for improved rheological properties and stress reduction. For underfill applications the filler will be electrically nonconductive. Examples of suitable nonconductive fillers include alumina, aluminum hydroxide, silica, vermiculite, mica, wollastonite, calcium carbonate, titania, sand, glass, barium sulfate, zirconium, carbon black, organic fillers, and halogenated ethylene polymers, such as, tetrafluoroethylene, trifluoroethylene, vinylidene fluoride, vinyl fluoride, vinylidene chloride, and vinyl chloride.

The filler particles may be of any appropriate size ranging from nano size to several mm. The choice of such size for any particular end use is within the expertise of one skilled in the art. Filler may be present in an amount from 10 to 90% by weight of the total composition. More than one filler type may be used in a composition and the fillers may or may not be surface treated. Appropriate filler sizes can be determined by the practitioner, but, in general, will be within the range of 20 nanometers to 100 microns.

### EXAMPLES

EXAMPLE 1. In this example, various compounds were tested for performance as fluxes applied directly to solder, as would be done prior to a capillary flow operation. Performance was measured as the time in seconds it took for the fluxing agent to collapse a solder ball. Copper or gold-plated copper coupons were used as substrates and the solder was a lead-free Sn_{95.5}Cu_{3.8}Ag_{0.7} solder having a melting point of 217°C. (The melting point of the solder will vary depending on the actual metallurgy.) The substrate coupons were preheated on a hot plate to 240°C (a temperature higher than the melting point of the solder), five to ten mg of fluxing agent were dropped onto the heated hot plate, and then four to six granules of solder, enough to make a solder ball, were dropped onto the fluxing agent. When a solder ball starts to flux, it rapidly collapses and merges into a solder glob that displays a shiny surface. This reaction was observed on all the examples tested and the time elapsed before the solder ball collapsed was recorded. Some of the results are reported above in this specification; other results are reported in the Table 1.

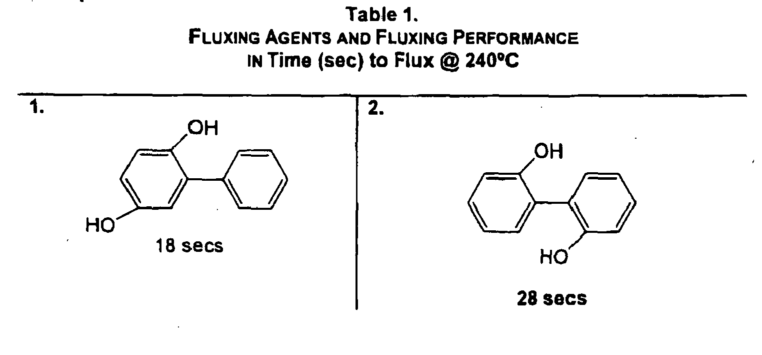

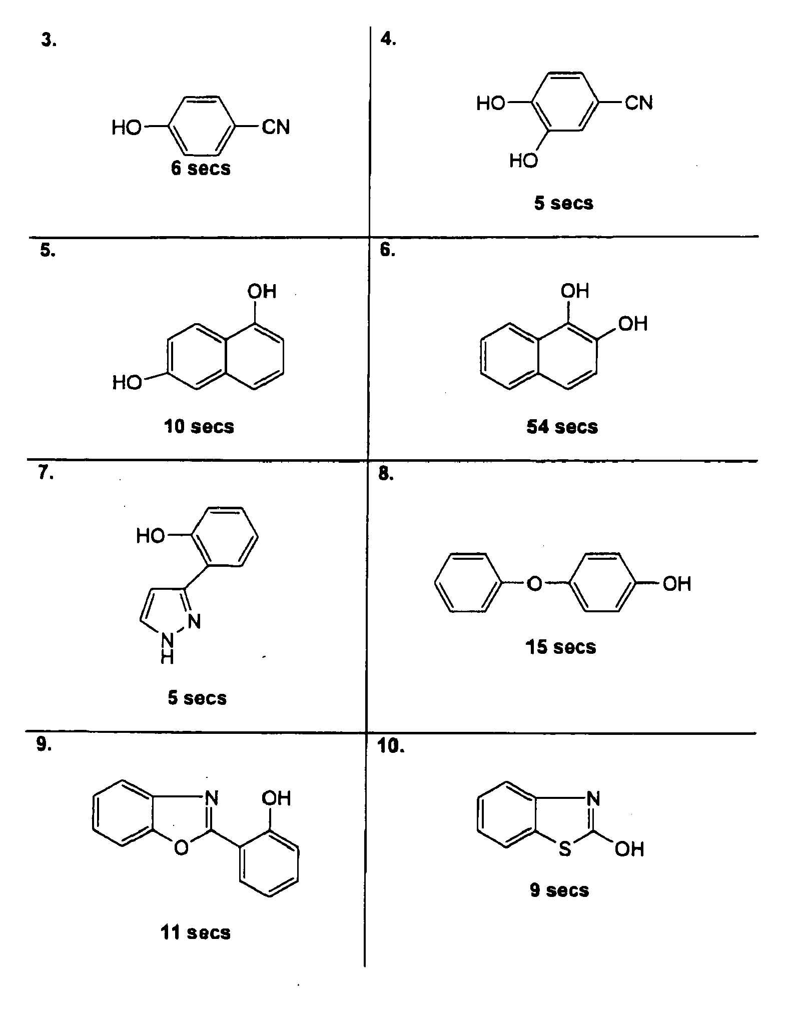

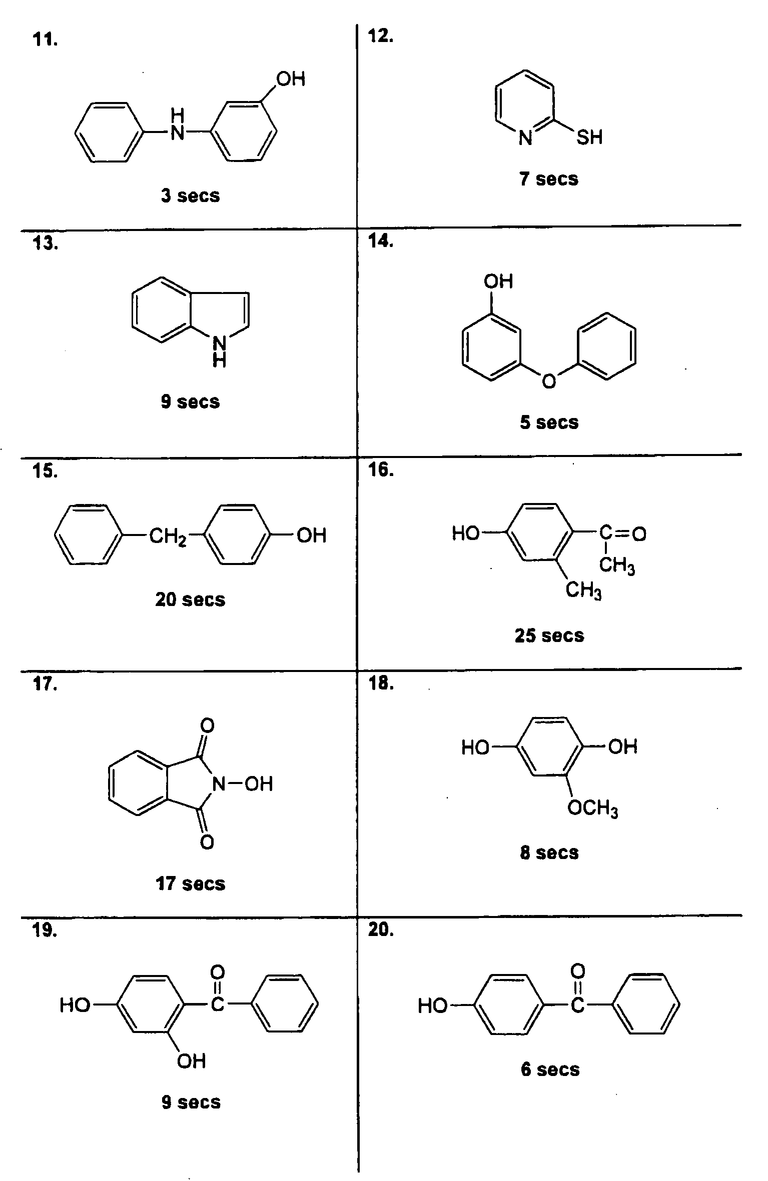

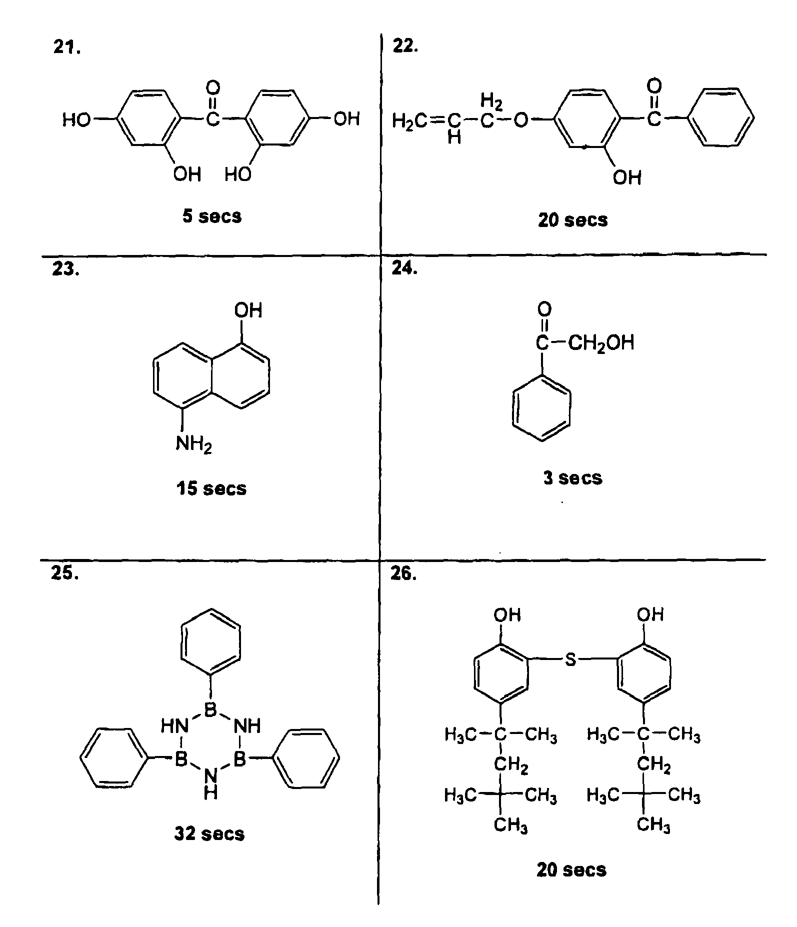

EXAMPLE 2. No-FLOW FLUXING COMPOSITIONS In this Example, fluxing agents were tested in no-flow fluxing underfill compositions. Assemblies of a solder bumped die and substrate were prepared using a thermal compression Toray Bonder to establish electrical interconnections between the bumped die and the substrates. The fluxing compositions were dispensed onto a BT substrate covered by solder mask with the exposed traces being Ni/Au plated onto Cu. A silicon die (5x5 mm) bumped with Sn_{95.5}Cu_{3.8}Ag_{0.7} solder bumps was aligned with the exposed traces on the substrate. The substrate was heated to 80°C and the die and substrate contacted with pressure of 20 Newtons in the thermal compression bonder. The die was then heated in ramped profile from 200°C to 220°C within 1-2 seconds and held at 220°C for 5-6 seconds to form an assembly of silicon die and substrate. The electric connections of the solder joints were confirmed by measuring the resistance across the circuits using an Agilent 34401 Digit Muttimeter.

Two fluxing compositions were used for testing, designated either Platform A, disclosed in Table 2, or Platform B, disdosed in Table 3. The control formulations for these platforms were the same as reported, except that the controls contained no fluxing agents. Neither of the control formulations had interconnections established in the thermal compression bonding process, indicating that the solder did not flux in the absence of the fluxing agent.

The inventive fluxing compositions, Platforms A and B, were formulated with chosen fluxing agents and in all cases fluxing was observed. The quality of the solder joints was examined by scanning electronic microscopy (SEM) (Hitachi S-3000N).

PLATFORM A FORMULATIONS AND RESULTS. A fluxing agent having the structure 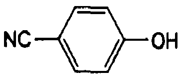 was formulated independently into the Platform A composition to make a fluxing composition as indicated in Table 2.

| TABLE 2. PLATFORM A: EPOXY/CYANATE ESTER FORMULATION (percent by weight) | | |
|---|---|---|
| Fluxing agent | 5% | Sigma-Aldrich |
| Epoxy | 13.36% | Epiclon 830CRP (Dainippon Ink Chemicals) |
| Cyanate Ester | 10.08% | XU71787.07L (Dow Chemical) |
| Cyanate Ester | 7.56% | Primaset LECY (Lonza), |
| Epoxy | 10.0% | Bisphenol F/ epichlorohydrin RSL-1739 (Resolution Performance Products) |
| Epoxy | 3.92% | Epiclon N-730A (Dainippon Ink Chemicals), |
| Catalyst | 0.08% | Cobalt(II) Acetylacetonate (98%, Sigma-Aldrich), |
| Rheology Modifier | 0.01% | Modaflow Resin Modifier (Solutia Inc.) |
| Filler | 50% | Admafine Silica SO-E5 (Admatechs Company, Ltd.). |

The interconnection was checked immediately after thermal compression bonding and again after further curing for two hours at 160°C. The electric interconnection showed little change before and after curing and both assemblies passed the electrical test indicating electrical connection. SEM pictures are shown in Figure 1 and indicate good solder wetting and solder joint quality. Without the use of the fluxing agent, the Platform A resin was not able to achieve solder fluxing and the silicon die and substrate assembly did not pass the electrical test.

PLATFORM B FORMULATIONS AND RESULTS. Two fluxing agents having the structures 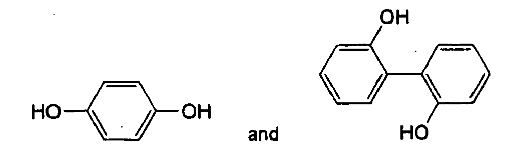 were formulated independently into the Epoxy resin composition to make two fluxing compositions as indicated in Table 3.

| TABLE 3. PLATFORM B: EPOXY FORMULATION (percent by weight) | | |
|---|---|---|
| Fluxing agent | 5% | Sigma-Aldrich |
| Epoxy | 25%% | Bisphenol F/epichlorohydrin epoxy internal material (National Starch and Chemical Co.) |
| Epoxy | 15.0% | Bisphenol F/ epichlorohydrin RSL-1739 (Resolution Performance Products) |
| Epoxy | 4.5% | Tris(2,3-epoxypropyl) isocyanurate (Sigma-Aldrich), |
| Silane adh. Promoter | 0.13% | Z6040 w Corning) |
| Defoamer | 0.01% | BYK-A-500 (BYK Chemie USA, Inc.) |
| Imidazole catalyst | 0.15% | Phenylmethylimidazole, 10 micron particles (National Starch and Chemical) |
| Rheology Modifier | 0.1% | Disperbyk-1080 (BYK-Chemie USA, Inc), |
| Antifoamer | 0.0005% | Antifoam 1400 (Dow Corning) |
| Filler | 50% | Admafine Silica SO-E5 (Admatechs Company, Ltd.). |

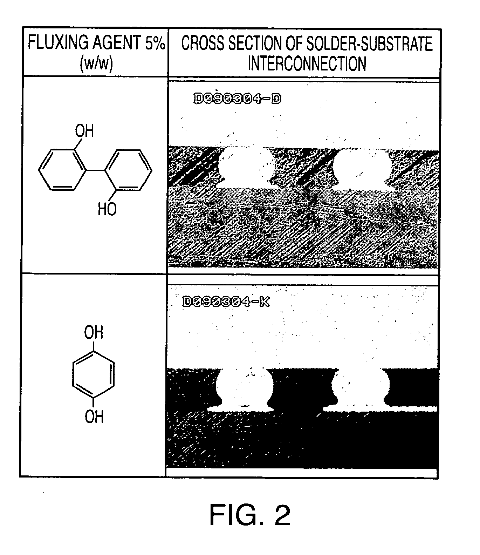

The fluxing compositions were tested according to the procedure described for Example 2. The interconnection was checked immediately after thermal compression bonding and again after further curing for two hours at 160°C. The electric interconnection showed little change before and after curing and both assemblies passed the electrical test. SEM pictures are shown in Figure 2 and indicate good solder wetting and solder joint quality. Without the use of the fluxing agent, the Platform B resin was not able to achieve solder fluxing and the silicon die and substrate assembly did not pass the electrical test.

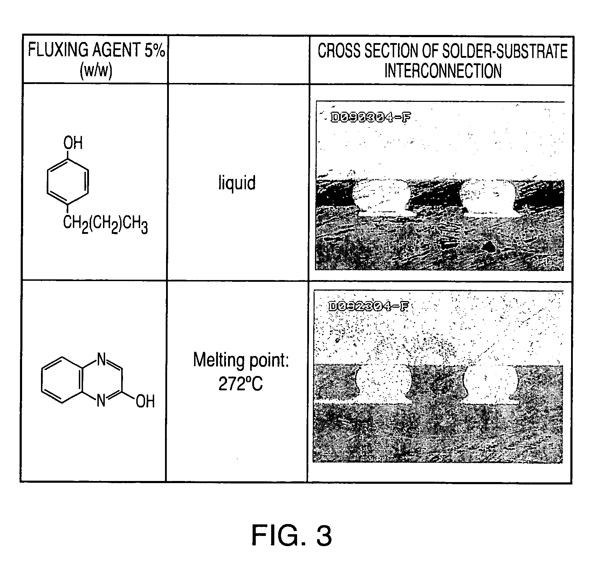

PLATFORM B WITH LIQUID AND SOLID FLUXING AGENTS. A liquid fluxing agent having the structure: 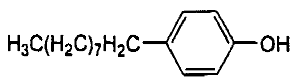 and a solid fluxing agent with a high melting point (>272°C) having the structure: 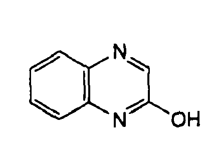 were formulated independently into the Platform B resin composition to make two fluxing compositions. The fluxing compositions were tested according to the procedure used in Example 2. The interconnection was checked immediately after thermal compression bonding and again after further curing for two hours at 160°C. The electrical interconnection showed little change before and after curing and both assemblies passed the electrical test. Note that although the solid fluxing agent with a high melting point of 272°C was insoluble in the Platform B composition at room temperature, it became sufficiently soluble at the bonding temperature of 220°C and was able to flux the solder to allow a good interconnection. SEM pictures are shown in Figure 3 and show good solder wetting and solder joint quality.

EXAMPLE 3. CAPILLARY FLOW UNDERFILL. EUTECTIC SOLDER. Two BT substrates covered by solder mask with the exposed traces being Ni/Au plated onto Cu and two 10x10 mm silicon dies bumped with eutectic solder Pb₆₃Sn₃₇, were brushed with fluxing agents prior to solder reflow and capillary flow underfill operations as described in the Background section of this specification. One set of parts was brushed with a commercial fluxing agent sold by Kester as product number 6502. The other set was brushed with a fluxing agent comprising a solution of 3-hydroxy-2-methyl-4-pyrone 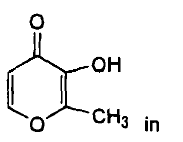 tripropylene glycol (3% w/w). The parts were dried in air and the die bonded to the substrate using a GSM Flipchip die bonder. The electric connections of the solder joints were confirmed by measuring the resistance across the circuits using an Agilent 34401 Digit Multimeter. The capillary flow underfill, which was a proprietary composition comprising a cyanate ester resin, was dispensed along the edge of the die and allowed to flow between the die and substrate. The parts were then cured at 165°C for 2 hours Electric connections were checked again, and the parts examined using optical microscopy and scanning acoustic microscopy to check for flux residue and voids. The commercial fluxing agent demonstrated excessive reactivity with the cyanate ester resin, resulting in severe flux residue and voids, particularly around the solder areas.

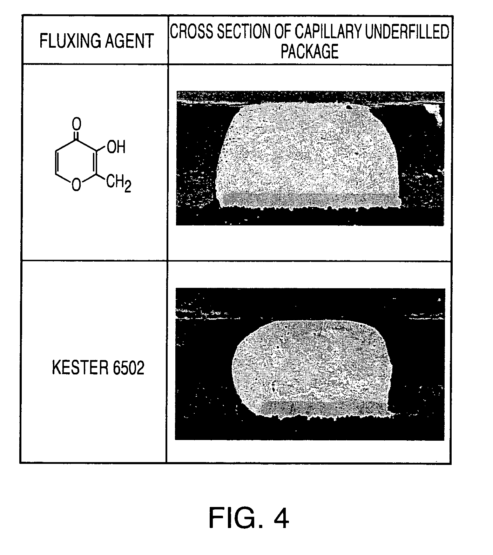

In contrast, as can be seen in the SEM pictures of Figure 4, the 3-hydroxy-2-methyl-4-pyrone showed no flux residue at all and no voids were observed. The same results: no residue, no voids, were achieved using 4-methylumbelliferone (Aldrich Cat. No. M1381) (2% w/w in tripropylene glycol) and using 4-cyanophenol in di(propylene glycol) methylether (46% w/w) as the fluxing agent.

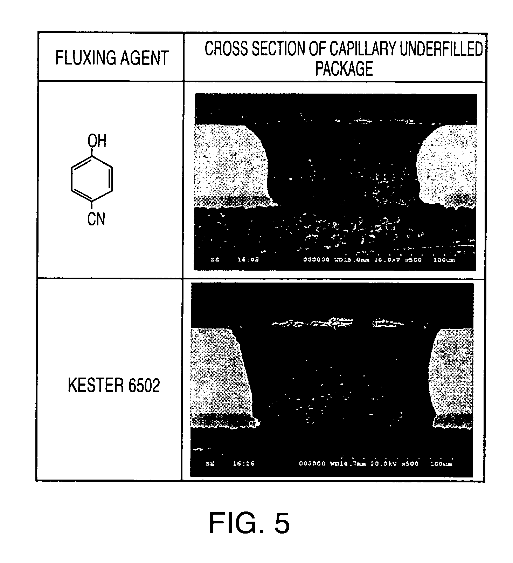

EXAMPLE 4. CAPILLARY FLOW UNDERFILL. LEAD-FREE SOLDER. The same test as was conducted in Example 3 was conducted here except that 4-cyanophenol in di(propylene glycol) methylether (46% w/w) was used as the fluxing agent and the solder was a lead free solder Sn_{95.5}Cu_{3.8}Ag_{0.7}. The commercial fluxing agent Kester 6502 again resulted in severe flux residue, particularly around the solder areas, due to its reactivity with cyanate ester resins. In contrast, the use of 4-cyanophenol as the fluxing agent showed no flux residue at all. Only very minor voids were observed. The SEM pictures are shown in Figure 5.

EXAMPLE 5. CAPILLARY FLOW. HIGH LEAD SOLDERS. The same test as was performed in Example 3 was performed here, except that the die was bumped with a high lead solder, Pb₉₅Sn5, and the fluxing agent was a solution of 4-cyanophenol in di(propylene glycol) methylether (46% w/w). The control fluxing agent was EB399, a product of Cookson. The substrates in this case were BT with solder-on-pad circuitry. Both packages showed no fluxing residues from cross section examinations. However, the use of EB399 as flux resulted in voiding, presumably due to its volatile reaction products with the cyanate ester resin. In contrast, as can be seen from the acoustic scanning picture in Figure 6, the assembly treated with 4-cyanophenol showed no voiding at all.

## Claims

1. A fluxing composition comprising a fluxing agent, in which the fluxing agent is a compound having (i) an aromatic ring, (ii) at least one -OH, -NHR (where R is hydrogen or lower alkyl), or -SH group, (iii) an electron-withdrawing or electron-donating substituent on the aromatic ring, and (iv) no imino group.

2. The fluxing composition according to claim 1 further comprising a thermosetting resin.

3. The fluxing composition according to claim 2 in which the thermosetting resin is selected from the group consisting of cyanate esters, epoxies, maleimides, bismaleimides, acylates, methacrylates, vinylethers, or mixtures of those.

4. The fluxing composition according to claim 3 in which the thermosetting resin is a cyanate ester.

5. The fluxing composition according to claim 3 in which the thermosetting resin is an epoxy.

6. The fluxing composition according to claim 3 in which the thermosetting resin is a blend of cyanate ester and epoxy.

7. The fluxing composition according to claim 2 further comprising a nonconductive filler.

8. The fluxing composition according to claim 6 in which the filler is selected from the group consisting of untreated silica, treated silica, untreated alumina, and treated alumina.

9. The fluxing composition according to claim 2 further comprising a curing agent or catalyst selected from the group consisting of transition metal catalysts, aromatic amines, aliphatic amines, and organic peroxides.

10. The fluxing composition according to claim 8 in which the transition metal catalysts are selected from the group consisting of transition metal complexes and organometallic complexes.

11. The fluxing composition according to claim 9 in which the catalyst is selected from the group consisting of Co(II)(AcetoAcetonate), Cu(II)(AcetoAcetonate), Mn(II)(AcetoAcetonate), Ti(AcetoAcetonate), and Fe(II)(AcetoAcetonate).

12. The fluxing composition according to claim10 in which the aromatic amines are selected from the group consisting of imidazoles, pyrazoles, triazoles, aminobenzenes, aliphatic amines, and aromatic amines.
